# EUROPEAN PATENT APPLICATION

(11) **EP 2 838 324 A1**
(43) Date of publication of application: **18.02.2015**
(21) Application number: 13776393.4
(22) Date of filing: 27.02.2013
(51) Int. Cl.: H05H 1/50, C23C 14/32, C23C 14/48

(54) **PLASMA GENERATION DEVICE, VAPOR DEPOSITION DEVICE, AND VAPOR DEPOSITION METHOD**

(30) Priority: 09.04.2012 JP 2012088547
(71) Applicant: Chugai Ro Co., Ltd., Osaka-shi Osaka 541-0046 (JP)
(72) Inventor: FURUYA, Eiji, Osaka-shi, Osaka 541-0046 (JP); AKANO, Shinya, Osaka-shi, Osaka 541-0046 (JP)
(74) Representative: Glawe, Delfs, Moll
(86) International application number: PCT/JP2013/055230
(87) International publication number: WO 2013/153864

(57) **Abstract**

There is provided a plasma generation apparatus capable of forming plasma suitable for a plasma assist method. The plasma generation apparatus includes a chamber 2, a plasma gun 3 arranged so as to face an inside of the chamber 2, and having a cathode 7 for emitting electrons and a convergent coil 11 for forming a magnetic flux to guide the electrons emitted by the cathode 7, and an auxiliary magnet 4 for forming a magnetic flux in the chamber 2, in which an excitation current is applied to the convergent coil 11 so as to vary a direction of the magnetic flux.

## Description

### TECHNICAL FIELD

The present invention relates to a plasma generation apparatus, a deposition apparatus, and a deposition method.

### BACKGROUND ART

There is a commonly-known deposition apparatus which uses a plasma assist method for promoting deposition by forming plasma. In the case where the plasma assist method is used, when a deposition target body such as a glass substrate is arranged close to the plasma, the deposition target body is overheated and ion sputtering is generated on its surface, so that a film formed by the deposition could be damaged.

A plasma gun, in general, includes a convergent coil for forming a magnetic flux to guide emitted electrons. Thus, according to deposition apparatus disclosed in a patent document 1 and a patent document 2, a magnetic flux formed by the convergent coil is bent, or a bent composite magnetic field is formed, with a magnet so that plasma is formed near a crucible for a deposition raw material. However, when a distance between the deposition target body and the plasma is large, a problem is that the vaporized raw material is low in activity, and a film quality is deteriorated.

### PRIOR ART DOCUMENT

### PATENT DOCUMENTS

Patent Document 1: Japanese Patent Laid-open Publication No. 7-76770
Patent Document 2: Japanese Patent Laid-open Publication No. 2001-295031

### SUMMARY OF THE INVENTION

### PROBLEMS TO BE SOLVED BY THE INVENTION

In view of the above problems, it is an object of the present invention to provide a plasma generation apparatus capable of forming plasma suitable for a plasma assist method, and a deposition apparatus and a deposition method capable of forming a high-quality film by the plasma assist method without damaging a deposition film.

### SOLUTIONS TO THE PROBLEMS

To solve the above problems, a plasma generation apparatus of the present invention includes a chamber; a plasma gun arranged so as to face to an inside of the chamber, and having a cathode for emitting electrons and a convergent coil for forming a magnetic flux to guide the electrons emitted by the cathode; and an auxiliary magnet for forming a magnetic flux in the chamber, wherein an excitation current is applied to the convergent coil to vary a direction of the magnetic flux.

According to this configuration, in tandem with a current variation of the excitation current, a path of a composite magnetic flux of the magnetic flux formed by the convergent coil and the magnetic flux formed by the auxiliary magnet is varied. Thus, a range in which the plasma is formed is bent or elongated so that the range in which the plasma is formed is moved, more typically, it is brought close to or pulled away from the auxiliary magnet. As a result, the plasma is moved, and it is possible to prevent the problem that the deposition target body is overheated when the range of the plasma is fixed.

In addition, according to the plasma generation apparatus in the present invention, the plasma gun is a pressure-gradient type plasma gun including a first electrode and a second electrode provided between the cathode and the convergent coil, the second electrode has an in-electrode coil arranged in its inside, and the plasma generation apparatus may apply an in-electrode current varying in synchronization with the excitation current, to the in-electrode coil.

According to this configuration, since a direction of the magnetic flux formed by the in-electrode coil conforms to the direction of the magnetic flux formed by the convergent coil, the electrons emitted from the cathode can be easily trapped by the magnetic flux formed by the convergent coil, so that the movement of the electrons is stabilized. Therefore, tolerance for the variation of the excitation current in which the plasma can be stably generated is high, and the plasma generation range is quickly moved to follow the current variation.

In the plasma generation apparatus according to the present invention, the excitation current and the in-electrode current may have similar periodic waveforms having the same phase, and make the excitation coil and the in-electrode coil form the magnetic fluxes having the same polarity.

According to this configuration, since the polarity of the excitation coil completely coincides with that of the in-electrode coil, the movement of the electrons is stabilized, and the excitation current and the in-electrode current can be generated with a circuit controlled by the same power supply or the same control signal, so that the configuration can be simple.

In the plasma generation apparatus according to the present invention, the auxiliary magnet may be arranged outside the chamber on an opposite side of the plasma gun such that a direction of a magnetic pole intersects with an axis of the plasma gun.

According to this configuration, since the auxiliary magnet can bend the composite magnetic flux such that it is deviated from the axis of the plasma gun, the plasma generation range can be easily fluctuated.

In addition, a first aspect of a deposition apparatus according to the present invention includes any one of the above-described plasma generation apparatus.

In addition, a second aspect of a deposition apparatus according to the present invention is a deposition apparatus for performing deposition with plasma formed by emitting electrons into a chamber holding a deposition target body and, wherein the deposition apparatus performs the deposition while varying a magnetic flux path for guiding the electrons emitted into the chamber.

The deposition method according to the present invention is for performing deposition with plasma formed by emitting electrons into a chamber holding a deposition target body while varying a magnetic flux path for guiding the electrons emitted into the chamber.

According to the deposition apparatus and the deposition method, while the deposition target film is prevented from being deteriorated due to the overheating of the deposition target body, activity of the vaporized raw material is enhanced and quality of the deposition target film can be improved.

### EFFECTS OF THE INVENTION

As described above, according to the present invention, since the path of the magnetic flux for guiding the electrons is varied, the plasma generation range can be moved, so that an action of the plasma can be adjusted.

### BRIEF DESCREIPTION OF THE DRAWINGS

Fig. 1 is a schematic configuration diagram of a deposition apparatus according to a first embodiment of the present invention.
Fig. 2 is a schematic configuration diagram of a deposition apparatus according to a second embodiment of the present invention.

### EMBODIMENTS OF THE INVENTION

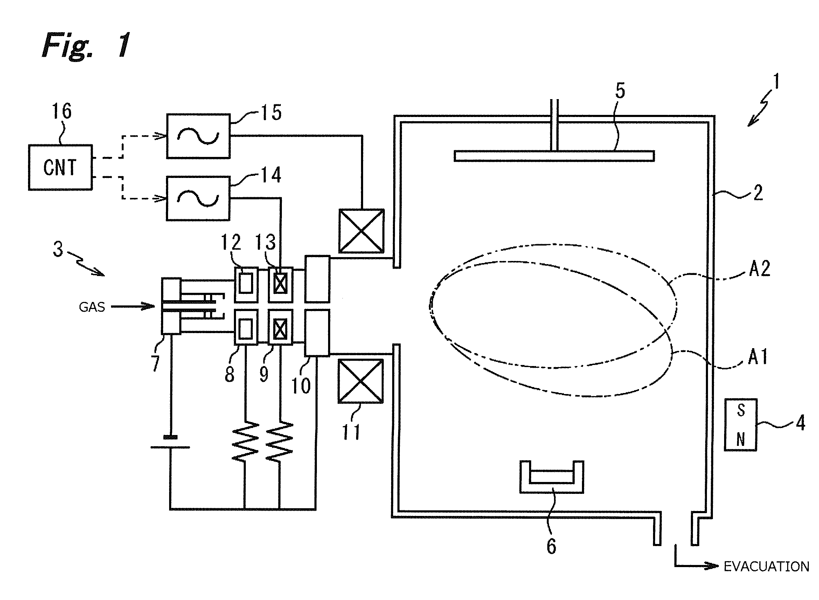

Hereinafter, embodiments of the present invention will be described with reference to the drawings. Fig. 1 shows a configuration of a deposition apparatus 1 according to a first embodiment of the present invention. The deposition apparatus 1 includes a chamber 2 whose inside can be evacuated, a pressure-gradient type plasma gun 3 arranged so as to face to the inside of the chamber 2 through an opening provided in a side wall of the chamber 2, and an auxiliary magnet 4 arranged outside a side wall of the chamber 2, on an opposite side of the plasma gun 3.

In the chamber 2, a glass substrate 5 serving as a deposition target body having a surface on which metal is to be vapor-deposited is held in an upper portion of its internal space, and a crucible 6 is arranged in a bottom portion thereof to dissolve a deposition raw material.

The plasma gun 3 has a cathode 7 for emitting electrons, a first electrode 8 and a second electrode 9 for forming a potential gratitude along an electron orbit, a feedback electrode 10 for collecting electrons emitted from the cathode 7, and a convergent coil 11 for forming a magnetic flux which guides the electrons emitted from the cathode 7. The first electrode 8 is a hollow ring-shaped electrode housing a permanent magnet 12 in its inside. The second electrode 9 is a hollow ring-shaped electrode housing an in-electrode coil 13 serving as an air core coil, in its inside. The plasma gun 3 injects ionized plasma gas such as argon through centers of the cathode 7, the first electrode 8, the second electrode 9, the feedback electrode 10, and the convergent coil 11.

In addition, the plasma gun 3 has an in-electrode excitation power supply 14 composed of an inverter for applying an in-electrode current serving as an alternate current to the in-electrode coil 13 of the second electrode 9, a convergent excitation power supply 15 composed of an inverter for applying an excitation current serving as an alternate current to the convergent coil 11, and a control device 16 for controlling the in-electrode excitation power supply 14 and the convergent excitation power supply 15. As for the in-electrode excitation power supply 14 and the convergent excitation power supply 15, a winding direction is the same, that is, a direction of the magnetic flux generated with respect to each applied current is the same. In addition, according to this embodiment, the control device 16 controls the in-electrode excitation power supply 14 and the convergent excitation power supply 15 so that synchronized sine wave currents having the same frequency and the same phase are outputted.

The auxiliary magnet 4 is arranged such that its position is shifted from a center axis of the plasma gun 3 and a direction between both poles intersects with the center axis of the plasma gun 3, more specifically, its S pole is arranged so as to face to the direction of the center axis of the plasma gun 3.

When the convergent coil 11 forms the magnetic flux so that the N pole is provided on the side of the chamber 2, the magnetic flux formed by the convergent coil 11 is drawn toward the auxiliary magnet 4. That is, a composite magnetic field of the magnetic flux formed by the convergent coil 11 and the magnetic flux formed by the auxiliary magnet 4 is bent so as to be deviated from the center axis of the plasma gun 3 and drawn toward the auxiliary magnet 4. The electrons emitted from the plasma gun 3 are moved so as to be tangled in the magnetic flux, so that a range in which the plasma is formed by ionizing the gas injected from the plasma gun 3 is also bent toward the auxiliary magnet 4 as shown by a range A1 illustrated by one-dot chain line.

When the convergent coil 11 forms the magnetic flux so that the S pole is provided on the side of the chamber 2, the magnetic flux formed by the convergent coil 11 and the magnetic flux formed by the auxiliary magnet 4 repel each other, so that a continuous magnetic flux for guiding the electrons emitted from the plasma gun 3 cannot be formed. Therefore, the electrons go straight substantially along the center axis of the plasma gun 3 without being guided by the magnetic flux and forms the plasma in a region roughly along the center axis of the plasma gun 3 as shown by a range A2 illustrated by two-dot chain line. In addition, the range in which the plasma is formed is separated from the auxiliary magnet 4 in some cases, depending on a balance between the magnetic flux formed by the convergent coil 11 and the magnetic flux formed by the auxiliary magnet 4.

Therefore, when the convergent excitation power supply 15 applies the alternate excitation current to the convergent coil 11, the range in which the plasma is formed is fluctuated in synchronization with the excitation current. That is, the plasma in the chamber 2 is repeatedly brought close to and pulled away from the glass substrate 5 in the same cycle as that of the excitation current applied to the convergent coil 11.

In this way, according to the deposition apparatus 1, since the plasma is periodically pulled away from the glass substrate 5, a heat amount which the glass substrate 5 receives from the plasma can be reduced. As a result, the deposition target film can be prevented from being deteriorated due to an excessive increase in temperature of the glass substrate 5. At the same time, since the plasma which activates vaporized deposition raw material molecule is periodically brought close to the glass substrate 5, a film quality and film formation efficiency can be improved.

In addition, in the plasma gun 3, since the in-electrode current which is synchronized with the excitation current is applied to the in-electrode coil 13 of the second electrode 9, the magnetic flux formed by the in-electrode coil 13 and the magnetic flux formed by the convergent coil 11 are integrated, so that the composite magnetic flux is formed so as to penetrate an inside of the plasma gun 3. Therefore, the electrons emitted from the cathode 7 are caught by the magnetic fluxes formed by the convergent coil 11 and the in-electrode coil 13, in the plasma gun 3, and even after discharged into the chamber 2, they go along the magnetic flux of the convergent coil 11. Thus, a transfer path of the electrons can promptly follow the variation of the magnetic flux of the convergent coil 11, so that the plasma formation range can be stably fluctuated.

In addition, just after startup of the plasma gun 3, the excitation current and the in-electrode current are to be a direct current because the cathode 7 is low in temperature and the electrons are unstable, and it is preferable that the excitation current is varied after the temperature of the cathode 7 has been increased so that the thermal electrons has become a stable emitted state.

According to this embodiment, in order to adjust the deposition condition, the control device 16 may adjust the fluctuation range and the fluctuation cycle of the plasma by changing output waveforms or changing the frequencies of the in-electrode excitation power supply 14 and the convergent excitation power supply 15. In addition, when the frequencies of the in-electrode current and the excitation current are high, large losses are caused in the convergent coil 11 and the in-electrode coil 13 due to a skin effect, so that upper limits of their frequencies are preferably set to about several hundreds of Hz.

In addition, in view of an influence of an external magnetic field or the like, the phase of the in-electrode current to be applied to the in-electrode coil 13, and the phase of the excitation current to be applied to the convergent coil 11 may be shifted to each other a little. Furthermore, in order to implement simplification, the current may be applied to the convergent coil 11 and the in-electrode coil 13 from the same power supply. In addition, the auxiliary magnet 4 loses magnetic force when heated to a temperature equal to or higher than Curie temperature, so that it is preferably arranged outside the chamber, but the auxiliary magnet 4 may be arranged in the chamber and cooled therein.

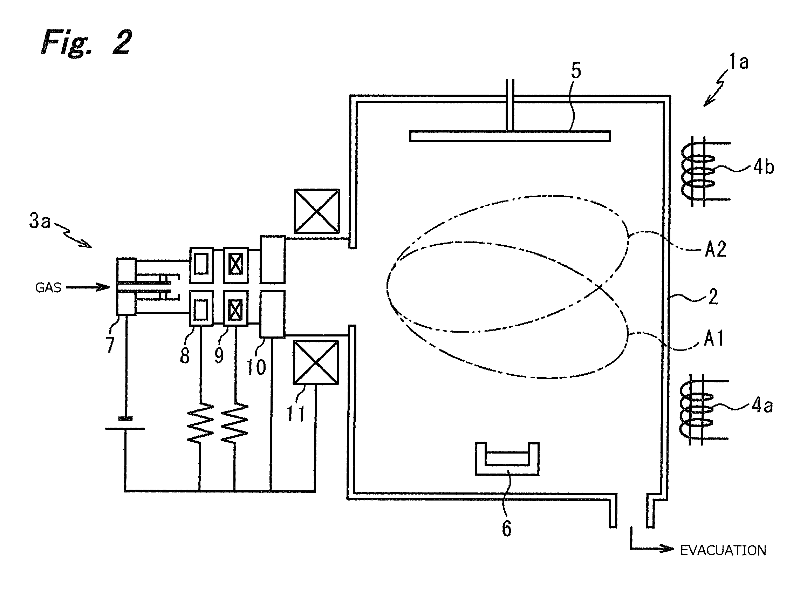

Next, Fig. 2 illustrates a deposition apparatus 1a according to a second embodiment of the present invention. In this embodiment, the same component as in the first embodiment is marked with the same reference sign, and a redundant description is omitted.

According to a plasma gun 3a in this embodiment, only a direct current is applied to the convergent coil 11 and the in-electrode coil 13 like the conventional example. According to this embodiment, instead of varying the magnetic flux generated by the convergent coil 11, the path of the magnetic flux generated by the convergent coil 11 to guide the emitted electrons is moved by two auxiliary magnets 4a and 4b arranged outside the chamber 2 on the opposite side of the plasma gun 3.

The auxiliary magnets 4a and 4b are each composed of an electromagnet, and they are arranged across a center axis of the plasma gun 3a so as to be positioned on a side opposite to the glass substrate 5 and on a side close to the glass substrate 5. Auxiliary currents periodically varying and having phases shifted by 90°, for example are applied to the auxiliary magnets 4a and 4b from power supplies (not shown). That is, according to this embodiment, the magnetic fluxes generated by the two auxiliary magnets 4a and 4b are periodically varied, so that a composite magnetic flux of the convergent coil 11 and the auxiliary magnets 4a and 4b are fluctuated.

According to this embodiment also, since the path of the magnetic flux for guiding the electrons emitted by the plasma gun 3a is fluctuated in the chamber 2, it is possible to prevent the glass substrate 5 from being overheated, and activate the vaporized metal molecule.

In addition, only the one magnetic flux formed by the auxiliary magnet 4a or 4b may be fluctuated, or many auxiliary magnets may be used. The phase difference between the auxiliary currents applied to the auxiliary magnets 4a and 4b and their waveforms may be changed to adjust the condition of the deposition. In addition, an auxiliary magnet composed of a permanent magnet may be moved mechanically.

Furthermore, according to the present invention, it is possible to combine the method for varying the magnetic flux formed by the convergent coil 11 according to the first embodiment, and the method for varying the magnetic fluxes formed by the auxiliary magnets 4a and 4b according to the second embodiment.

In addition, it is possible to combine with plasma density control with up-slope and down-slope of a cathode output, in order to adjust the deposition condition, so that high-quality deposition can be implemented due to wider condition settings.

In addition, the present invention can be widely applied to a device and a method for promoting a process with plasma, other than the deposition.

### DESCRIPTION OF REFERENCE SIGNS

1, 1a: Deposition apparatus
2: Chamber
3, 3a: Plasma gun
4, 4a, 4b: Auxiliary magnet
5: Glass substrate (deposition target body)
6: Crucible
7: Cathode
8: First electrode
9: Second electrode
10: Feedback electrode
11: Convergent coil
12: Permanent magnet
13: In-electrode coil
14: In-electrode excitation power supply
15 Convergent excitation power supply
16 Control device
A1, A2: Plasma formation range

## Claims

1. A plasma generation apparatus comprising:
a chamber;
a plasma gun arranged so as to face to an inside of the chamber, and having a cathode for emitting electrons and a convergent coil for forming a magnetic flux to guide the electrons emitted by the cathode; and
an auxiliary magnet for forming a magnetic flux in the chamber, wherein
an excitation current is applied to the convergent coil to vary a direction of the magnetic flux.

2. The plasma generation apparatus according to claim 1, wherein
the plasma gun is a pressure-gradient type plasma gun comprising a first electrode and a second electrode between the cathode and the convergent coil,
the second electrode has an in-electrode coil arranged in its inside, and
an in-electrode current fluctuating in synchronization with the excitation current is applied to the in-electrode coil.

3. The plasma generation apparatus according to claim 2, wherein
the excitation current and the in-electrode current have similar periodic waveforms having the same phase, and make the excitation coil and the in-electrode coil form the magnetic fluxes having the same polarity.

4. The plasma generation apparatus according to any one of claims 1 to 3, wherein
the auxiliary magnet is arranged outside the chamber on an opposite side of the plasma gun such that a direction of a magnetic pole intersects with an axis of the plasma gun.

5. A deposition apparatus comprising the plasma generation apparatus according to any one of claims 1 to 4.

6. A deposition apparatus for performing deposition with plasma formed by emitting electrons into a chamber holding a deposition target body and, wherein
the deposition apparatus performs the deposition while varying a magnetic flux path for guiding the electrons emitted into the chamber.

7. A deposition method for performing deposition with plasma formed by emitting electrons into a chamber holding a deposition target body while varying a magnetic flux path for guiding the electrons emitted into the chamber.

## Amended claims

### Amended claims under Art. 19.1 PCT

**1.** A plasma generation apparatus comprising:
a chamber;
a plasma gun arranged so as to face to an inside of the chamber, and having a cathode for emitting electrons and a convergent coil for forming a magnetic flux to guide the electrons emitted by the cathode; and
an auxiliary magnet for forming a magnetic flux in the chamber, wherein
an excitation current is applied to the convergent coil to vary a direction of the magnetic flux,
the plasma gun is a pressure-gradient type plasma gun comprising a first electrode and a second electrode between the cathode and the convergent coil,
the second electrode has an in-electrode coil arranged in its inside, and
an in-electrode current fluctuating in synchronization with the excitation current is applied to the in-electrode coil.

**2.** (deleted)

**3.** The plasma generation apparatus according to claim 1, wherein
the excitation current and the in-electrode current have similar periodic waveforms having the same phase, and make the excitation coil and the in-electrode coil form the magnetic fluxes having the same polarity.

**4.** The plasma generation apparatus according to claim 1, wherein
the auxiliary magnet is arranged outside the chamber on an opposite side of the plasma gun such that a direction of a magnetic pole intersects with an axis of the plasma gun.

**5.** A deposition apparatus comprising the plasma generation apparatus according to any one of claims 1, 3 and 4.

**6.** (deleted)

**7.** (deleted)
The description of "the plasma gun is a pressure-gradient type plasma gun comprising a first electrode and a second electrode between the cathode and the convergent coil, the second electrode has an in-electrode coil arranged in its inside, and an in-electrode current fluctuating in synchronization with the excitation current is applied to the in-electrode coil" of claim 1 is based on a description of claim 2.
